# EUROPÄISCHE PATENTSCHRIFT

(11) **EP 0 591 750 B1**
(45) Veröffentlichungstag und Bekanntmachung des Hinweises auf die Patenterteilung: **06.08.1997**
(21) Anmeldenummer: 93115154.2
(22) Anmeldetag: 21.09.1993
(51) Int. Cl.: H03K 19/003

(54) **Verfahren zur Stromeinstellung eines monolithisch integrierten Padtreibers**
Method for adjusting the current in a monolithic integrated output driver
Méthode pour régler le courant d'un circuit d'attaque de sortie intégré monolithique

(30) Priorität: 08.10.1992 DE 4233850
(43) Veröffentlichungstag der Anmeldung: 13.04.1994
(73) Patentinhaber: Deutsche ITT Industries GmbH, 79108 Freiburg (DE)
(72) Erfinder: Giebel, Burkhard, Dipl.-Ing., D-79211 Denzlingen (DE)

(56) Entgegenhaltungen:
- EP-A- 0 363 505
- WO-A-89/03614
- IBM TECHNICAL DISCLOSURE BULLETIN, Bd.30, Nr.9, Februar 1988, ARMONK, US Seiten 174 - 176 'Low L di/dt Noise Off-Chip Driver.'

## Beschreibung

Die Erfindung betrifft ein Verfahren zur Stromeinstellung eines monolithisch integrierten Padtreibers, der insbesonders für hohe Datenraten und große Lastkapazitäten ausgelegt ist. Eine hohe Stromergiebigkeit und hohe Umschaltgeschwindigkeit derartiger Padtreiber ist eine wichtige Voraussetzung für den raschen Austausch von immer größer werdenden Datenmengen zwischen zusammenwirkenden Datenverarbeitungseinrichtungen. Selbst innerhalb einer hochintegrierten Schaltung kann eine leistungsfähige Treiberschaltung erforderlich werden, wenn an eine digitale Signalquelle innerhalb des Chips eine Vielzahl von Teilschaltungen, die eine erhöhte Lastkapazität darstellen, zu schließen sind.

Der bekannte Nachteil von leistungsfähigen Padtreibern besteht darin, daß die Dimensionierung des Ausgangsstromes, der im folgenden auch als Laststrom bezeichnet wird, durch den Minimalstrom bestimmt wird, der unter den ungünstigsten technologischen und äußeren Bedingungen noch eine sichere Datenübertragung ermöglichen muß. Der tatsächliche Ausgangsstrom ist also in der Regel infolge der üblichen Toleranzen viel zu groß, z.B. um den Faktor 5, und erzeugt über das Spannungsversorgungssystem kaum beherrschbare Spannungseinbrüche und Störsignale, die kapazitiv oder induktiv wirksam werden können. Zusätzlich ist der Stromverlauf bekannter Padtreiber in der Regel stark impulsförmig mit einem ausgeprägten Strommaximum, so daß die Spannungseinbrüche im Versorgungssystem weiter vergrößert werden. Dies wirkt sich vor allen Dingen auf gegebenenfalls vorhandene analoge Signalverarbeitungsstufen aus. Bei einer Analog-Digital- oder Digital-Analog-Umsetzung werden dann störende Signalkomponenten erzeugt, die durch Mischungseffekte in das Nutzsignalband gelangen. Die Beseitigung derartiger Störungen ist nach der Erfindung möglich, wenn durch ein geeignetes Verfahren und eine zugehörige Schaltungsanordnung der Wert und die Toleranz des jeweiligen Ausgangsstromes genauer eingestellt und eingehalten werden können.

Das Verfahren zur Stromeinstellung von Padtreibern nach der Erfindung ist daher auch nicht nur auf die Padtreiber von reinen Ausgangsanschlüssen beschränkt, sondern auch auf interne Treiberstufen anzuwenden. Der Begriff "Padtreiber" ist daher im weitestumfassenden Sinn zu verstehen.

Aus DE-A- 40 27 534 ist beispielsweise ein CMOS-Padtreiber bekannt, bei dem durch Strombegrenzungsmaßnahmen der Spitzenstrom reduziert wird, um Störeffekte auf den internen Speiseleitungen zu beseitigen. Die Strombegrenzung besteht dabei aus einem zusätzlichen Schaltungselement in der Art einer großflächigen Diode im Querstrompfad der komplementären Ausgangstransistoren. Durch die Dimensionierung der wirksamen Sperrschichtfläche dieser Diode wird der maximale Durchlaßstrom festgelegt.

In "IBM-Technical Disclosure Bulletin", Bd. 30, Nr. 9, Februar 1988, Seiten 174 - 176 wird beschrieben, daß zur Stromeinstellung eines Padtreibers in einem ersten Bereich der Ausgangsspannung die Ausgangstransistoren als stromgesteuerte Elemente und in einem zweiten Bereich als spannungsgesteuerte Elemente betrieben werden. Die Umschaltung in den jeweiligen Bereich wird über elektronische Schalteinrichtungen von der Ausgangsspannung des jeweiligen Treibers gesteuert. Die elektronischen Schalteranordnungen, Stromquellen und Stromspiegel sind in CMOS-Technik ausgeführt, vgl. den Oberbegriff des Anspruchs 1.

In WO 89/03614 sind ebenfalls Padtreiber in CMOS-Technik beschrieben, die ebenfalls einen Zweibereichsbetrieb aufweisen, vgL den Oberbegriff des Anspruchs 1. Das vom Ausgang des Padtreibers rückgeführte Signal wird mit einer Verzögerungsstufe gegenüber der Ausgangsspannung verzögert, wobei die Verzögerungszeit kleiner als die Umschaltdauer der Ausgangsspannung ist. Die Schaltung enthält Schaltereinrichtungen aus p- und n-Kard-Transistoren. Über unterschiedliche Kanalbreiten der Transistoren werden die Schwellenspannungen variiert, um die Funktion des Padtreibers zu optimieren. Die in dem einen Bereich in der Steilheit verlangsamten Flanken des Padtreiberausganges werden dadurch erreicht, daß durch eine p- oder n-Kanal-Diodenstrecke die mittels CMOS-Invertern gebildete Gate-Ansteuerspannung der Ausgangstransistoren im Hub begrenzt wird.

Aufgabe der in den Ansprüchen gekennzeichneten Erfindung ist es, ein verbessertes Verfahren zur Stromeinstellung von Padtreibern anzugeben, bei dem der Absolutwert und die Toleranz des Ausgangsstromes genauer einstellbar sind und insbesondere die Laststromspitze verhindert wird.

Die Lösung dieser Aufgabe erfolgt, indem der zeitliche Verlauf des Ausgangsstromes des Padtreibers dadurch bestimmt wird, daß in einem ersten Spannungsbereich des Padtreibers ein Ausgangstransistor als stromgesteuertes Element und in einem zweiten Bereich als spannungsgesteuertes Element betrieben wird, vgl. den Wortlaut des Anspruchs 1.

Die Erfindung und weitere vorteilhafte Ausführungen werden nun anhand der Figuren der Zeichnung näher erläutert:
Fig. 1 zeigt schematisch als Blockschaltbild eine bekannte Padtreiberschaltung für ein CMOS-Ausgangstransistorpaar,
Fig. 2 zeigt als Zeitdiagramm den zugehörigen tatsächlichen Verlauf des Laststromes und dazu den gewünschten Stromverlauf,
Fig. 3 zeigt den Laststromverlauf als Funktion der Ausgangsspannung beim Stand der Technik und beim Verfahren nach der Erfindung,
Fig. 4 zeigt schematisch ein besonders einfaches Ausführungsbeispiel der Erfindung,
Fig. 5 zeigt schematisch ein Ausführungsbeispiel mit verbesserter Stromeinstellung,
Fig. 6 zeigt schematisch ein Ausführungsbeispiel mit einer Vielzahl von Padtreibern, deren Ausgangsströme durch eine gemeinsame Stromquellen-Steuerspannung eingestellt werden, und
Fig. 7 zeigt schematisch ein besonders vorteilhaftes Ausführungsbeispiel, bei dem die Stromquellen-Steuerspannung mittels einer PLL-Schaltung auf dem Chip ohne externe Bauelemente gebildet wird.

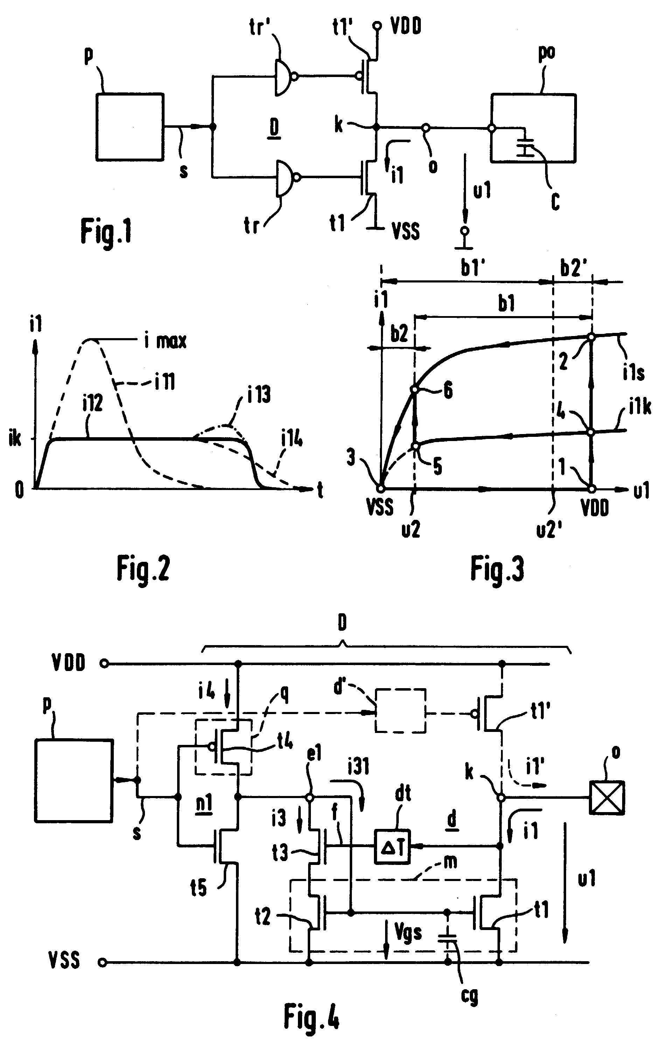

Fig. 1 zeigt das Blockschaltbild eines bekannten Padtreibers, der beispielsweise in DE-A 40 27 534 beschrieben ist. Eine Signalquelle p liefert ein einphasiges oder gegenphasiges Signal s, das über eine untere Treiberstufe tr die Steuerelektrode eines n-Kanal-Ausgangstransistors t1 ansteuert. Über einen oberen Signalpfad steuert das Signal s einen oberen Treiber tr' an, dessen Ausgang mit dem Gate-Anschluß eines p-Kanal-Ausgangstransistors t1' verbunden ist. Die untere und obere Treiberstufe sind z.B. jeweils als CMOS-Inverter ausgeführt und das komplementäre Ausgangstransistorpaar t1', t1 ist als Serienschaltung zwischen die positive und negative Versorgungsspannung VDD bzw. VSS geschaltet. Der gemeinsame Schaltungsknoten k liegt am Ausgangsanschluß o, der mit einem Ausgangspad und/oder mit internen Teilschaltungen auf dem Chip verbunden ist. Die Summe aller Signalempfänger po stellt dabei für den Ausgangsanschluß o eine Lastkapazität C dar, die entsprechend dem Signal s umgeladen werden muß. Der Entladestrom durch den Ausgangstransistor t1 ist der Laststrom i1.

In Fig. 2 stellt die gestrichelte Linie i11 den üblichen Stromverlauf über der Zeitachse t dar, wie er sich beispielsweise bei der Entladung der Lastkapazität C von Fig. 1 ergibt. Zunächst steigt der Strom i11 rasch auf einen maximalen Strom imax an und geht schließlich wieder auf den Wert Null zurück. Der impulsartige Laststrom i11 bewirkt eine unnötig steile Umschaltflanke und über die impulsartige Stromspitze einen Spannungseinbruch auf den Versorgungsleitungen. Für eine sichere Datenübermittlung über den Ausgangsanschluß o ist es nach der Erfindung indessen völlig ausreichend, wenn der Laststrom i1 auf dem Niveau eines Konstantstromes ik weit unterhalb des Maximalstromes imax begrenzt wird, vgl. den Stromverlauf i12 von Fig. 2.

In Fig. 3 ist zur Schaltungsanordnung von Fig. 1 die zugehörige Kennlinie des Laststromes i1 als Funktion der Drain-Source-Spannung des Transistors t1, die der Pad-Ausgangsspannung u1 gleich ist, wie folgt dargestellt. Der impulsförmige Laststromverlauf i11 von Fig. 2 ergibt sich daraus, daß bei der Entladung der Lastkapazität C die einzelnen Kennlinienbereiche nacheinander durchlaufen werden und zwar entsprechend der Punktefolge 1, 2 und 3. Die Entladung der auf die positive Versorgungsspannung VDD aufgeladenen Lastkapazität C beginnt bei Punkt 1. Der Entladestrom i1 erreicht über den senkrechten Kennlinienbereich sehr rasch seinen Maximalwert imax (vgl. Fig. 2) bei Punkt 2, von wo ab sich die Entladekennlinie bis zum Punkt 3 an die statische Ausgangskennlinie i1s des Transistors t1, die für die Gate-Source-Spannung Vgs = VDD gilt, anschmiegt. Der Maximalwert bei Punkt 2 wird bei der tatsächlichen Entladung der Lastkapazität C infolge der endlichen Schaltzeiten der Transistoren erst mit kurzer Zeitverzögerung erreicht, vgl. hierzu Fig. 2. Im dynamischen Fall wandert der Kennlinienpunkt 2 daher etwas auf der Kennlinie i1s in Richtung eines kleineren Laststrommaximums.

An der Aufladung der Lastkapazität C ist Transistor t1 nicht beteiligt, daher hat der Strom i11 bzw. i1 zwischen den Kennlinienpunkten 3 und 1 den Wert Null. In Punkt 1 schließt sich der Kennliniendurchlauf - der Entladevorgang kann von neuem beginnen.

In Fig. 4 ist ein besonders einfaches Ausführungsbeispiel eines Padtreibers D dargestellt, mit dem das Verfahren zur Stromeinstellung nach der Erfindung ausgeführt werden kann. Eine Signalquelle p liefert wie in Fig. 1 ein Signal s an einen unteren und oberen Signalpfad, die jeweils eine Padtreiber-Halbstufe d bzw. d' enthalten, um den unteren bzw. oberen Ausgangstransistor t1 bzw. t1' anzusteuern. In der unteren Padtreiber-Halbstufe steuert das Signal s eine Treiberstufe an, die aus einem CMOS-Inverter n1 gebildet ist. Der zugehörige p-Kanal-Transistor t4 ist dabei so dimensioniert, daß er durch das Signal s in den Sperrzustand oder in einen gesättigten Zustand gelangt. Im gesättigten Zustand bildet er eine Stromquelle q, die mit einem Steuereingang e1 eines Stromspiegel m verbunden ist. Dieser Stromspiegel spiegelt den Strom der Stromquelle q in den Ausgangstransistor t1, wobei ein festes Übersetzungsverhältnis den Laststrom i1 in gewünschter Weise vergrößert.

Der Stromeingang des Stromspiegels m wird durch einen zweiten Transistor t2 gebildet, dessen Fußpunkt ebenfalls mit der negativen Versorgungsspannung VSS verbunden ist und dessen Steuerelektrode gemeinsam mit der Steuerelektrode des Ausgangstransistors t1 am Steuereingang e1 liegt. Über das W/L-Verhältnis der beiden Stromspiegel-Transistoren t1 und t2 und die Stromquelle q wird der gewünschte Laststrom i1 des Ausgangstransistors t1 eingestellt. Der Stromeingang des Stromspiegels m wird mit dem Ausgangsstrom i4 der Stromquelle q gespeist. Dies erfolgt über eine Schalteranordnung, die einen dritten Transistor t3 enthält, der als n-Kanal-Transistor zwischen dem Steuereingang e1 und dem Stromeingang des Stromspiegels m liegt. Die Steuerelektrode des dritten Transistors t3 ist über eine Verzögerungsstufe dt mit dem gemeinsamen Schaltungsknoten k und dem Ausgangsanschluß o verbunden. Somit gelangt über die Verzögerungsstufe dt die Ausgangsspannung u1 um eine Zeit ΔT verzögert als Rückführsignal f auf die Steuerelektrode des dritten Transistors t3.

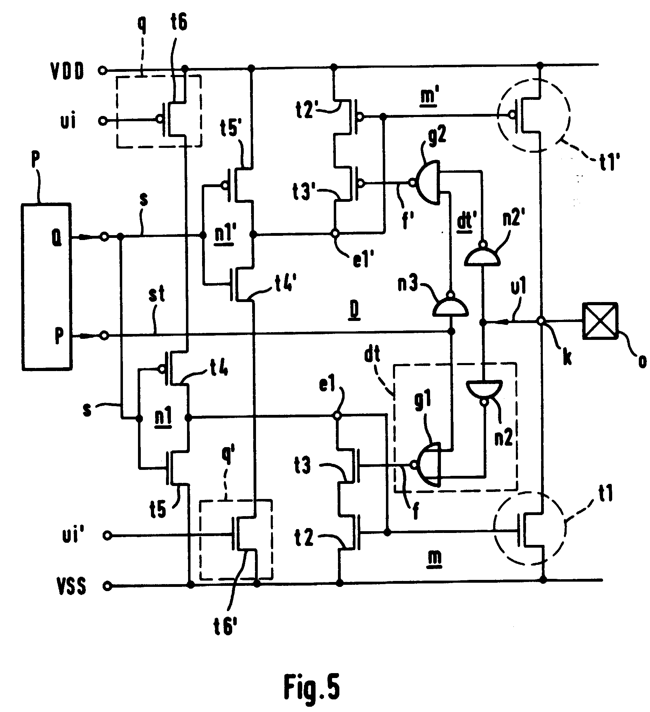

Entsprechend der Erfindung wird durch die Schaltung nach Fig. 4 erreicht, daß im mittleren sowie im oberen Aussteuerbereich (= erster Bereich b1) der Ausgangsspannung u1 der dritte Transistor t3 durchgeschaltet wird, so daß der Strom i4 der Stromquelle q als Strom i3 durch den dritten Transistor t3 auf den Stromeingang des Stromspiegels m gelangt, vgl. auch Fig. 5. Hingegen wird bei niederer Ausgangsspannung u1 (= zweiter Bereich b2) der dritte Transistor t3 gesperrt, so daß der Strom i4 nicht auf den Stromeingang des Stromspiegels m gelangt, sondern als Strom i31 direkt auf den Gate-Anschluß des Ausgangstransistors t1. Dort dient er lediglich dazu, die Gate-Kapazität des Ausgangstransistors t1, die in Fig. 4 als Ersatzkapazität cg schematisch dargestellt ist, rasch umzuladen. Im Gegensatz hierzu wird in Fig. 1 der Ausgangstransistor t1 über die niederohmige Treiberstufe tr und nicht über eine Stromquelle angesteuert.

Im Kennlinienfeld von Fig. 3 ist auch die Ausgangskennlinie des Transistors t1 der Schaltung nach Fig. 4 enthalten. Der gesamte Entladevorgang der Lastkapazität C bildet dabei ebenfalls wieder eine geschlossene Kennlinie, die durch die Punkte 1, 4, 5, 6, 3 und schließlich wieder 1 umschrieben wird.

Nach der Erfindung beginnt die Entladung der auf die positive Versorgungsspannung VDD aufgeladenen Lastkapazität C wieder bei Punkt 1. Über den senkrechten Kennlinienbereich wird bei Punkt 4 sehr rasch der Stromquellenbetrieb erreicht, der weit unter dem Maximalwert liegt, der durch Punkt 2 bestimmt wird. Gemäß der Stromquellencharakteristik des über den Stromspiegel m angesteuerten Ausgangstransistors t1 bleibt sein Ausgangsstrom i1 relativ konstant und folgt einer Konstantstromkennlinie i1k bis zum Punkt 5. Im einfachen Ausführungsbeispiel von Fig. 4 ist die zugehörige Gate-Source-Spannung Vgs des Ausgangstransistors t1 für die Kennlinie i1k etwa Vgs = VDD/3.

Würde die Stromspiegel-Ansteuerung der Ausgangsstufe über den Punkt 5 hinaus beibehalten, würde sich die Ausgangsspannung u1 mit einem immer geringer werdenden Laststrom i14 (vgl. Fig. 2) dem Endpotential bei Punkt 3 auf der Kennlinie i1k nähern.

Dieser Nachteil der Stromspiegel-Ansteuerung wird nach der Erfindung durch die Einfügung des Schalttransistors t3 in den Stromspiegeleingang behoben. Sobald der Schalttransistor t3 nicht mehr von der Ausgangsspannung u1 durchgeschaltet werden kann, was beim Erreichen der Schwellenspannung u2 bei Punkt 5 geschieht, fließt der Ausgangsstrom i4 der Stromquelle q nicht mehr durch die in Serie geschalteten Transistoren t3, t2 nach dem Fußpunkt des Stromspiegels m ab, sondern lädt als Strom i31 das Gate des Ausgangstransistors t1 auf die volle positive Versorgungsspannung VDD auf. Die Gate-Source-Spannung Vgs steigt rasch vom niederen Wert, z.B. VDD/3, auf VDD an. Dementsprechend springt im Kennlinienfeld von Fig. 3 der Laststrom i1 von Punkt 5 auf Punkt 6. Dies bewirkt eine rasche Restentladung der Lastkapazität C auf der Kennlinie i1s bis zum Punkt 3.

Der sprungartige Anstieg des Laststromes i1 zwischen den Punkten 5 und 6 läßt sich durch schaltungstechnische Maßnahmen im dynamischen Betrieb so verschleifen, daß je nach Wunsch eine leichte Stromerhöhung i13 (Fig. 2) oder ein glatter Verlauf i12 (Fig. 2) vorgegeben werden kann. Dies wird in den Ausführungsbeispielen nach Fig. 4 und Fig. 5 beispielsweise durch die Einfügung der Verzögerungsstufe dt erreicht. Die verzögerte Ansteuerung des Transistors t3 verschiebt gleichsam die Schwellenspannung u2 und damit Punkt 5 auf der Kennlinie i1k in Richtung Punkt 3. Fig. 3 zeigt, daß die Sprunghöhe des Laststromes i1 zwischen den Punkten 5 und 6 um so kleiner wird, je näher Punkt 5 an Punkt 3 rückt.

Der erste und zweite Spannungs-Bereich b1 bzw. b2 in Fig. 3 ist durch die Lage der Schwellenspannung u2 definiert, die für den Enladestrompfad über den Transistor t1 dicht bei der negativen Versorgungsspannung VSS liegen soll. Für den Aufladestrompfad über den Transistor t1' soll die zugehörige Schwellenspannung u2' dicht bei der positiven Versorgungsspannung VDD liegen. Für den Aufladestrom über den Transistor t1' ist der Stromverlauf von Fig. 3 spiegelbildlich zu vertauschen. Die Spiegelachse verläuft dabei durch die mittlere Versorgungsspannung.

Durch die Verzögerungsstufe dt wird im dynamischen Betrieb eine Verschiebung der Schwellenspannung u2 des dritten Transistors t3 in Richtung der negativen Versorgungsspannung VSS bewirkt. Die in Fig. 3 beim Punkt 6 dargestellte Stromspitze des Stromverlaufs i1 wird damit kleiner als bei der tatsächlich vorhandenen Schwellenspannung u2.

Vereinfachend kann selbstverständlich der Steueranschluß des dritten Transistors t3 auch ohne die Verzögerungsstufe dt mit dem Schaltungsknoten k direkt verbunden werden.

In Fig. 4 ist lediglich die Padtreiber-Halbstufe d für den n-Kanal-Ausgangstransistors t1 dargestellt. Die obere Padtreiber-Halbstufe d' für den p-Kanal-Ausgangstransistor t1' ist spiegelbildlich zur unteren Padtreiber-Halbstufe d aufgebaut, wobei p- und n-Kanal-Transistoren sinngemäß vertauscht sind. Der symmetrische Aufbau des gesamten Padtreibers D ist zudem aus Fig. 5 deutlich entnehmbar. Außer den Ausführungsbeispielen in CMOS-Technik ist das Verfahren zur Stromeinstellung monolithisch integrierter Padtreiber auch auf andere Schaltungstechniken übertragbar, z.B. auf Einkanal-MOS- oder Bipolar-Technik.

Im Ausführungsbeispiel nach Fig. 5 sind die Schaltungsteile, die bereits in Fig. 4 ausführlich beschrieben sind, mit den gleichen Bezugszeichen versehen, so daß sich eine nochmalige Erörterung erübrigt. Ein wesentlicher Unterschied besteht in der Ausbildung der Stromquelle q und der nachfolgenden Schalteranordnung, die aus einem ersten Inverter n1 besteht. Der erste Inverter n1 in Fig. 5 ist ein üblicher CMOS-Inverter aus den komplementären Schalttransistoren t4, t5. Die Stromquelle q ist gegenüber Fig. 4 verändert, sie ist ein separater Schaltungsteil, der in Serie zum ersten Inverter n1 geschaltet ist. Damit hat der erste Inverter n1 eine reine Schalterfunktion. Im ersten Schaltzustand verbindet er den Ausgang der Stromquelle mit dem Steuereingang e1 und im zweiten Schaltzustand sperrt er den Stromquellenstrom gegenüber dem Steuereingang e1.

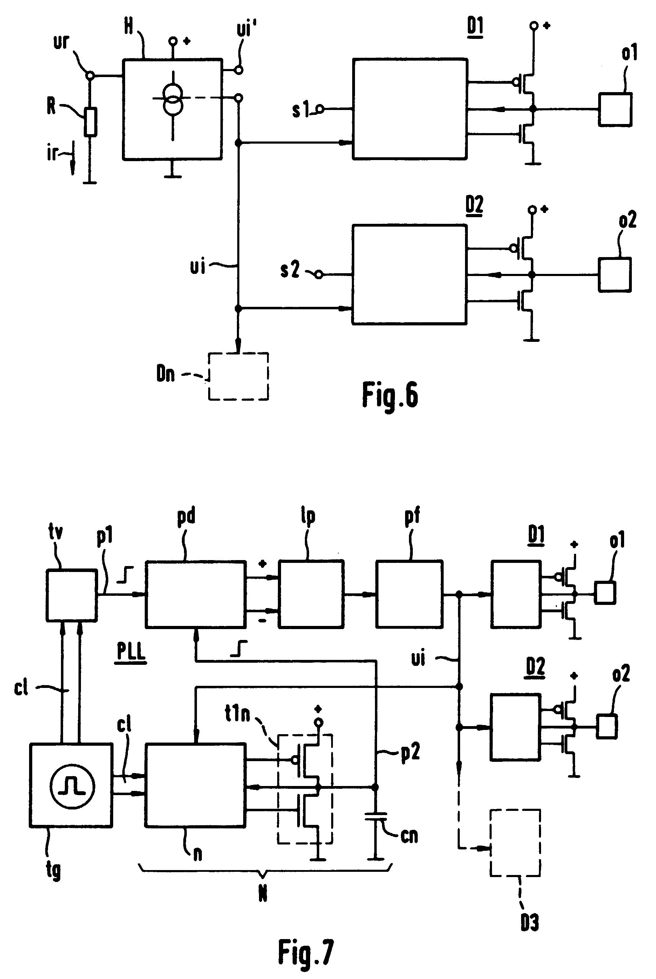

Die Stromquelle q wird durch einen sechsten Transistor t6 gebildet, der als p-Kanal-Transistor zwischen der positiven Versorgungsspannung und dem vierten Transistor t4 liegt. Die Steuerelektrode des sechsten Transistors t6 ist an eine Stromquellen-Steuerspannung ui angeschlossen, die beispielsweise die Steuerspannung einer p-Kanal-Strombank oder einer anderen Stromreferenz sein kann. Durch die separate Ausbildung der Stromquelle q in Fig. 5 kann der Eingangsstrom des Stromspiegels m wesentlich genauer eingestellt werden, als wenn die Stromquelle mit dem Transistor t4 wie in Fig. 4 kombiniert ist. Zudem können an die Stromquellen-Steuerspannung ui mehrere Padtreiber D1, D2, Dn angeschlossen werden, so daß auch eine relativ aufwendige, damit aber genaue Hilfsschaltung für die Stromquellen-Steuerspannung ui gerechtfertigt ist. Die Ausführungsbeispiele von Fig. 6 und Fig. 7 zeigen besonders vorteilhafte Ausführungsbeispiele für die Erzeugung der Stromquellen-Steuerspannung ui.

Ein weiterer Unterschied zu Fig. 4 stellt in Fig. 5 die Verzögerungsstufe dt dar. Sie enthält in Reihenschaltung einen Inverter n2 und ein NOR-Gatter g1, dessen zweiter Eingang mit einem Sperrausgang P der Signalquelle p verbunden ist. Durch ein Sperrsignal st kann der Transistor t3 im Stromeingang des Stromspiegels m dauernd gesperrt werden, so daß die Wirkung der Stromeinstellung nach der Erfindung unter Betriebsbedingungen getestet werden kann. Unter Umständen ist dies ein wichtiges Analysehilfsmittel zur Erkennung der verschiedenen Störungseinflüsse.

Die Verzögerungsstufe der oberen Padtreiber-Halbstufe ist komplementär aufgebaut, da ihr Ausgangssignal den p-Kanal-Transistor t3' sperren muß. Sie enthält als Serienschaltung ein NAND-Gatter g2, dessen erster und zweiter Eingang jeweils über einen Inverter n2' bzw. n3 mit dem Schaltungsknoten k bzw. dem Abschaltausgang P verbunden sind. Der symmetrische Aufbau der Schaltungsanordnung nach Fig. 5 zwischen der positiven und negativen Versorgungsspannung VDD bzw. VSS wird in der Darstellung dadurch hervorgehoben, daß gleichwirkende Schaltungsteile der symmetrischen Anordnung mit den gleichen Bezugszeichen versehen sind, wobei die Bezugszeichen der oberen Padtreiber-Halbstufe lediglich durch das zusätzliche Zeichen " ' " gekennzeichnet sind.

Fig. 6 zeigt schematisch eine Vielzahl von Padtreibern D1, D2, Dn, die beispielsweise dem Ausführungsbeispiel nach Fig. 5 entsprechen und denen als Stromquellen-Steuerspannung ui das Ausgangssignal einer Hilfsstromquelle H gemeinsam zugeführt wird. Die Hilfsstromquelle bestimmt den Pegel der Stromquellen-Steuerspannung ui beispielsweise mittels einer steuerbaren Stromquelle, die eine belastbare Referenzspannung ur erzeugt und mittels eines Widerstands R einen konstanten Referenzstrom ir bildet. Wenn mit diesem Referenzstrom ir der Eingang eines p-Kanal-Stromspiegels gespeist wird, dessen Fußpunkt an der positiven Versorgungsspannung VDD liegt, dann liefert die gemeinsame Gate-Spannung dieses Stromspiegels bereits die gewünschte Stromquellen-Steuerspannung ui. Wird der Ausgangsstrom dieses Stromspiegels mittels eines n-Kanal-Stromspiegels an der negativen Versorgungsspannung VSS gespiegelt, dann erhält man die Stromquellen-Steuerspannung ui' für die Stromquellen q' der oberen Padtreiber-Halbstufen, sofern diese Steuerspannung nicht intern durch eine Spiegelung in jedem Padtreiber selbst erzeugt wird. Da in integrierter Schaltungstechnik die Referenzspannung ur sehr genau und temperaturstabil erzeugt werden kann, läßt sich über einen externen Widerstand R der Referenzstrom ir genau einstellen. Von Nachteil ist lediglich das zusätzliche Anschlußbein und das externe Bauelement.

In Fig. 7 ist ein Ausführungsbeispiel dargestellt, das nach einem besonders vorteilen Verfahren die Erzeugung der Stromquellen-Steuerspannung ui ermöglicht und das für die Laststromeinstellung mit einer Referenzgröße auskommt, die bei den meisten integrierten Schaltungen sowieso schon vorhanden ist. Als Referenzgröße wird nämlich ein Taktnormal verwendet, das in der Regel als quarzgenaues System-Taktsignal auf jedem Chip verfügbar ist. Mit diesem Verfahren wird eine Stromquellen-Steuerspannung ui von hoher Genauigkeit erzeugt. Diese Schaltung ermöglicht, daß der Laststrom i1 technologische und umgebungsabhängige Parameter ausregelt. Zu diesem Zweck wird die steuerbare Stromquelle in der Hilfsstromquelle H durch eine Phasenverriegelungsschleife (= PLL) ersetzt, die als Regelstrecke die Umladungszeit einer nachgebildeten Ausgangslastkapazität cn auswertet. Die Umladung der nachgebildeten Lastkapazität cn wird mittels einer Padtreiber-Nachbildung N, die eine Ausgangstransistor-Nachbildung t1n enthält, bewirkt. Die Padtreiber-Nachbildung N enthält zu diesem Zweck eine Nachbildung n einer vollständigen Treiberstufe und eine an sie angeschlossene Ausgangstransistor-Nachbildung t1n sowie die genannte nachgebildete Lastkapazität cn. Die strombestimmenden Elemente der Nachbildungsschaltungen cn und t1n können im Hinblick auf die Stromergiebigkeit maßstabsgerecht verkleinert werden, wenn der Strom der Stromquelle in der Nachbildung n im gleichen Verhältnis verkleinert wird.

Die PLL vergleicht in einem Phasendetektor pd die Zeitdifferenz zwischen einem ersten und zweiten Flankensignal p1, p2, das bevorzugt aus der Taktverzögerungsstufe tv bzw. aus einer Umschaltflanke an der nachgebildeten Lastkapazität cn gewonnen wird. Die Zeitdifferenz null stellt dabei die Referenzgröße oder den Sollwert für die PLL-Regelschleife dar. Aus dem Taktnormal, das in der Regel ein quarzgesteuerter Taktgenerator tg auf dem Chip liefert oder das als ein externes Taktsignal cl zugeführt wird, wird mittels der Taktverzögerungsstufe tv das erste Flankensignal p1 gebildet, indem das Taktsignal cl beispielsweise um exakt einen halben Takt verzögert wird. Gleichzeitig wird das Taktsignal cl dem Signaleingang der Nachbildungsschaltung n zugeführt, die die Umladung der angeschlossenen Lastkapazitäts-Nachbildung cn bewirkt. Diese Umladungszeit dient in der PLL-Regelschleife als Stellgröße.

Der Phasendetektor pd wertet als Vergleichsgröße die Phasendifferenz des ersten und zweiten Flankensignals p1, p2 aus und steuert mit dem positiven oder negativen Abweichungssignal direkt die positive bzw. negative Stromquelle einer Ladungspumpe lp an, deren Ausgangssignal über ein Schleifenfilter pf geglättet wird. Das Ausgangssignal des Schleifenfilters pf ist bereits die gewünschte Stromquellen-Steuerspannung ui, die den Stromquellen-Steuereingängen der Padtreiber D1, D2, Dn und der Nachbildungsschaltung n zugeführt wird.

Auf diese Weise wird die Signallaufzeit der Nachbildungsschaltung n durch die PLL so gesteuert, daß sie immer genau die fest vorgegebene Laufzeit der Verzögerungsstufe tv aufweist. Über die Steuerspannung ui werden aber auch alle vorhandenen Ausgangsstufen D1, D2, D3 gesteuert. Bei gleichem Verhältnis von Stromergiebigkeit zu Lastkapazität der Nachbildungsschaltung N und der Ausgangsstufen D1, D2, D3 sind die jeweiligen Signallaufzeiten gleich. Damit sind die jeweiligen Lastströme i1 in ihrer Größe festgelegt.

Änderungen der Signallaufzeit, z.B. infolge von Versorgungsspannungseinflüssen oder Temperatureffekten, werden durch die PLL sofort ausgeregelt. Es werden aber auch Änderungen ausgeregelt, die sich aus technologischen Schwankungen im Herstellungsprozeß ergeben, so daß immer derjenige Laststrom zur Verfügung gestellt wird, der die gewünschte Umladungszeit der Lastkapazität ermöglicht.

Die Toleranzen der Lastkapazitäts-Nachbildung cn, die in der Regel über die jeweiligen Gate-Prozesse realisiert wird, sind im allgemeinen beim CMOS-Herstellungsprozeß recht gering. Zudem ist der Herstellungsprozeß zumindest identisch mit dem Herstellungsprozeß für die Signal-Eingangsstufen auf dem Chip. Gegebenenfalls kann die Nachbildung cn der Lastkapazität C durch eine extern anzuschließende Kapazität ersetzt oder ergänzt werden, um den Padtreiber an eine ursprünglich nicht bekannte Lastkapazität anzupassen.

Ein weiterer Vorteil des angegebenen Verfahrens zur Stromeinstellung von einem oder von mehreren Padtreibern besteht darin, daß die zugehörige Schaltung im Ruhezustand querstromfrei ist, weil der Strom der jeweiligen Stromquelle q durch die Schalteranordnung t3 vom Stromspiegeleingang getrennt wird. Damit ist im entladenen Zustand der Querstrompfad unterbrochen. Im geladenen Zustand muß der Stromspiegeleingang sowieso stromlos gehalten werden, so daß ebenfalls kein Querstrom fließen kann. Lediglich während des Entladevorgangs, und dann nur im ersten Spannungsbereich b1 (Fig. 3), ist der Querstrompfad über die Transistoren t3, t2 für den Strom i4 der Stromquelle q kurzzeitig offen.

## Patentansprüche

1. Verfahren zur Stromeinstellung eines Padtreibers (D; D1, D2, Dn), das in einem ersten Bereich (b1; b1') der Ausgangsspannung (u1) einen Ausgangstransistor (t1;t1') als stromgesteuertes Element und in einem zweiten Bereich (b2; b2') als spannungsgesteuertes Element betreibt, wobei
- die Umschaltung vom stromgesteuerten in den spannungsgesteuerten Betrieb des Ausgangstransistors (t1; t1') mittels einer elektronischen Schalteranordnung (t3, dt; t3', dt') erfolgt, die von einem von der Ausgangsspannung (u1) abhängigen Rückführungssignal (f; f') gesteuert ist,
- im ersten Bereich (b1; b1') Steuerelektrode des Ausgangstransistors (t1; t1') mittels eines Stromspiegels (m; m') aus einer Stromquelle (q; q') gespeist ist,
- im zweiten Bereich (b2; b2') die Steuerelektrode des Ausgangstransistors (t1; t1') ohne den Stromspiegel (m; m') aus der Stromquelle (q; q') gespeist ist, und
- die Stromquelle (q; q') mindestens einen Transistor (t6; t6') enthält, dessen Steuerelektrode mit einer Stromquellen-Steuerspannung (ui; ui') gespeist wird,
dadurch gekennzeichnet, daß
- die Stromquellen-Steuerspannung (ui; ui') mehreren Padtreibern (D; D1, D2, Dn) gemeinsam aus einer einzigen Hilfsstromquelle (H) zugeführt wird, die den Pegel der Stromquellen-Steuerspannung (ui; ui') mittels einer steuerbaren Stromquelle (ur, R; PLL) bestimmt, und
- das Rückführsignal (f; f') mittels einer Verzögerungsstufe (dt; dt') gegenüber der Ausgangsspannung (u1) verzögert wird, wobei die Verzögerungszeit (ΔT) kleiner als die Umschaltdauer der Ausgangsspannung (u1) ist.

2. Verfahren nach Anspruch 1, dadurch gekennzeichnet, daß der Pegel der Stromquellen-Steuerspannung (ui; ui') mittels eines externen Widerstandes (R) eingestellt wird, der an die Hilfsstromquelle (H) einen genauen Referenzstrom (ir) liefert.

3. Verfahren nach Anspruch 2, gekennzeichnet durch folgende Merkmale:
- die steuerbare Stromquelle wird durch eine Phasenverriegelungsschleife (PLL) gebildet,
- die Steflgröfe für die Phasenverriegdungsschleife (PLL) ist die Umladungszeit einer nachgebildeten Lastkapazität (cn) in einer Padtreiber-Nachbildung (N),
- die Vergleichsgröße für die Phasenverriegelungsschleife (PLL) ist die Taktverzögerung einer von einem Taktnormal (tg, cl) gespeisten Taktverzögerungsstufe (tv),
- die Abweichung der Umladungszeit vom Sollwert wird mittels eines Phasendetektors (pd) bestimmt, und
- die Signaleingänge des Phasendetektors (pd) sind mit den Ausgangssignalen der Taktverzögerungsstufe (tv) und der Padtreiber-Nachbildung (N) gespeist.

## Claims

1. A method of setting the output current of a pad driver (D; D1, D2, Dn) wherein an output transistor (t1; t1') is operated as a current-controlled element in a first range (b1; b1') of the output voltage (u1) and as a voltage-controlled element in a second range (b2; b2'),
- the changeover from the current-controlled mode to the voltage-conrolled mode of the output transistor (t1; t1') being effected by means of an electronic switch arrangement (t3, dt; t3', dt') which is controlled by a feedback signal (f; f') dependent on the output voltage (u1),
- the control electrode of the output transistor (t1; t1') being fed in the first range (b1; b1') from a current source (q; q') by means of a current mirror (m; m'),
- the control electrode of the output transistor (t1; t1') being fed in the second range (b2; b2') from the current source (q; q') without the current mirror (m; m'), and
- the current source (q; q') comprising at least one transistor (t6; t6') whose control electrode is fed with a current source control voltage (ui; ui'),
characterized in
- that the current source control voltage (ui, ui') is supplied to several pad drivers (D; D1, D2, Dn) from a single auxiliary current source (H) which determines the level of the current source control voltage (ui; ui') by means of a controlled current source (ur, R; PLL), and
- that the feedback signal (f; f') is delayed with respect to the output voltage (u1) by means of a delay stage (dt; dt') whose delay (ΔT) is shorter than the switching period of the output voltage (u1).

2. A method as claimed in claim 1, characterized in that the level of the current source control voltage (ui; ui') is set by means of an external resistor (R) which supplies the exact reference current (ir) to the auxiliary current source (H).

3. A method as claimed in claim 2, characterized by the following features:
- The controlled current source is formed by a phase-locked loop (PLL);
- the manipulated variable for the phase-locked loop (PLL) is the charging/discharging period of a simulated load capacitance (cn) in a pad-driver-simulating network (N);
- the reference variable for the phase-locked loop (PLL) is the delay of a clock-delay stage (tv) supplied with a standard clock signal (tg, cl);
- the deviation of the charging/discharging period from the set point is determined by means of a phase detector (PD), and
- the signal inputs of the phase detector (PD) are supplied with the output signals from the clock-delay stage (tv) and the pad-driver-simulating network (N).

## Revendications

1. Méthode pour régler le courant d'un circuit d'attaque de sortie (D ; D1, D2, Dn) qui fait travailler un transistor de sortie de sortie (t1 ; t1') en tant qu'élément commandé par le courant dans une première plage (b1 ; b1') de la tension de sortie (u1) et en tant qu'élément commandé par la tension dans une deuxième plage (b2 ; b2'), dans laquelle :
- la commutation du transistor de sortie de sortie (t1 ; t1') du travail à commande par le courant en travail à commande par la tension est réalisée au moyen d'un dispositif de circuit électronique (t3, dt ; t3', dt') qui est commandé par un signal de contre-réaction (f ; f') dépendant de la tension de sortie (u1),
- dans la première plage (b1 ; b1'), l'électrode de commande du transistor de sortie ( t1 ; t1') est alimentée à partir d'une source de courant (q ; q') au moyen d'un miroir de courant (m ; m'),
- dans la deuxième plage (b2 ; b2'), l'électrode de commande du transistor de sortie (t1 ; t1') est alimentée à partir de la source de courant (q ; q') sans le miroir de courant (m ; m'), et
- la source de courant (q ; q') comprend au moins un transistor (t6 ; t6') dont l'électrode de commande est alimentée par une tension de commande de la source de courant (ui ;
caractérisée en ce que
- la tension de commande de la source de courant (ui ; ui') est envoyée en commun à plusieurs circuits d'attaque de sortie (D ; D1, D2, Dn) à partir d'une seule source de courant auxiliaire (H) qui détermine le niveau de la tension de commande de la source de courant (ui ; ui') au moyen d'une source de courant pouvant être commandée (ur, R ; PLL) et
- le signal de contre-réaction (f ; f') est retardé par rapport à la tension de sortie (u1) au moyen d'un étage retardateur (dt ; dt'), la durée du retard étant plus petite que la durée de la commutation de la tension de sortie (u1).

2. Méthode selon la revendication 1, caractérisée en ce que le niveau de la tension de commande de la source de courant (ui ; ui') est réglé au moyen d'une résistance externe (R) qui fournit un courant de référence précis à la source de courant auxiliaire (H).

3. Méthode selon la revendication 1 ou 2, caractérisée par les particularités suivantes :
- la source de courant pouvant être commandée est constituée par une boucle à phase asservie (PLL),
- la grandeur de réglage pour la boucle à phase asservie (PLL) est la durée de la décharge d'une capacité de charge simulée (cn) dans une simulation (N) de circuit d'attaque de sortie,
- la grandeur de comparaison pour la boucle à phase asservie (PLL) est le retard d'horloge d'un étage retardateur d'horloge (tv) alimenté par une valeur standard d'horloge (tg, cl),
- la déviation de la durée de décharge à partir de la valeur de consigne est déterminée au moyen d'un détecteur de phase (pd), et
- les entrées de signal du détecteur de phase (pd) sont alimentées par les signaux de sortie de l'étage retardateur d'horloge (tv) et par la simulation (N) de circuit d'attaque de sortie.
